# EUROPEAN PATENT APPLICATION

(11) **EP 1 881 605 A1**
(43) Date of publication of application: **23.01.2008**
(21) Application number: 07111841.8
(22) Date of filing: 05.07.2007
(51) Int. Cl.: H03K 17/00

(54) **Touch detection method and system for a touch sensor**

(30) Priority: 19.07.2006 US 489776
(71) Applicant: Tyco Electronics Canada Ltd., Markham, ON L3R 1E1 (CA)
(72) Inventor: Paun, Traian, Markham Ontario L6E 1S7 (CA); Atanassov, Filip, Oakville Ontario L6H 7K3 (CA)
(74) Representative: Townsend, Stephen

(57) **Abstract**

A touch sensor (10) including a keyboard having a key defining a touch sensing location (fig.1: 14), wherein the key is responsive to at least one of capacitive and electromagnetic interactions with a user (16) during a touch event includes control circuitry (34) associated with the key, wherein the control circuitry (34) outputs a control signal, and wherein an amplitude of the control signal is representative of an amount of interaction between the user (16) and the key during a touch event. A controller is connected to the control circuitry and analyzes (36) a variation in the amplitude of the control signal (34) over a time period to identify the touch event.

## Description

This invention relates generally to touch sensors, and more specifically, to touch detection methods and systems for touch sensors.

Conventional touch sensing systems include a keyboard having multiple keys. Each key includes a conductive pad overlaid by a dielectric element. The conductive pad is connected to control circuitry that monitors the current level of the pad. Typically, the pad is supplied with a current having a constant amplitude, and when the key is touched by a user, the interaction between the user and the key changes the signal supplied to the key. By measuring an output signal of the key, the touch sensing system can detect when a touch event is occurring.

One problem with conventional touch sensing systems is that the systems are sensitive to multiple factors that affect the output signals of the key. As such, the system may detect a faulty touch or the system may fail to detect an actual touch event. At least some of these factors that affect the output signals of the key are caused by various problems, such as the thickness or type of dielectric material used for the key, the size or positioning of the keys, the size of the user's finger touching the key, the way that a user touches the key, interference caused by noise, unequal key sensitivities caused by manufacturing or environmental factors, drift in key sensitivity due to environmental factors like temperature or humidity, and touches by non-user objects such as metal objects, water, or animals.

At least some known touch sensing systems have addressed one or more of these problems. For example, a prior art touch sensing system for detecting faulty touches is described in U.S. Pat No. 5,760,715 ('715). In the '715 patent, a padless touch sensor is used for detecting a touch at a sensing location onto a dielectric element by a user coupled to earth. The sensor includes a conductive plate having a predetermined potential applied thereto. Simultaneously, test pulses are produced into earth. When the user touches the dielectric element at the sensing location, a potential variation in the conductive plate is produced during a test pulse due to a capacitive circuit formed between earth, the user and the sensor. As such, foreign matter or objects placed directly on top of the dielectric element will not erroneously produce a touch condition.

Other known touch sensing systems provide control algorithms or functions to compensate for some of these factors that affect the touch signal output from the key, such that the systems can more accurately measure the output signal. However, these control algorithms add complexity and expense to the overall system.

In one aspect, a touch sensor is provided including a keyboard having a key defining a touch sensing location, wherein the key is responsive to at least one of capacitive and electro-magnetic interactions with a user during a touch event. The keyboard includes control circuitry associated with the key, wherein the control circuitry outputs a control signal, and wherein an amplitude of the control signal is representative of an amount of interaction between the user and the key during a touch event. A controller is connected to the control circuitry and analyzes a variation in the amplitude of the control signal over a time period to identify the touch event.

Optionally, the key may exhibit capacitive coupling with the user during the touch event, and a capacitance level may increase as the user approaches the key. The variation in the amplitude of the control signal may constitute an approach speed of the user during the touch event. Optionally, the control signal may include a touch signal when the touch event occurs at the associated key and the control signal may include a non-touch signal when no touch event occurs at the associated key, wherein the controller analyzes the variation in the amplitude of the touch signal to verify that a touch event is occurring. The control signal may be varied based on a position of a user's body in relation to the key. The control signal may include a changing amplitude component and a constant amplitude component. Optionally, the controller may identify the touch event based on a touch pattern having the amplitude of the control signal varying when the user's body is moved toward the key and having the amplitude of the control signal remaining constant when the user's body is touching the key.

In another aspect, a touch detection system is provided including a touch sensing module having a key defining a touch sensing location. The key is responsive to at least one of capacitive and electro-magnetic interactions with a user during a touch event. A control module sends an input signal to the key, wherein an amplitude of the control signal is representative of an amount of interaction between the user and the key during a touch event, and wherein the amplitude of the input signal is changed during the touch event of the key. An analyzing module receives an output signal from the key, wherein the analyzing module analyzes a variation in an amplitude of the output signal over a time period to verify the touch event.

In a further aspect, a method is provided of detecting a touch event using a touch sensor having a key. The method includes generating an output signal at the key corresponding to a proximity of an object to the key, wherein an amplitude of the output signal is varied depending on the proximity of the object to the key. The method also includes analyzing a change in the amplitude of the output signals over a time period to determine that a touch event is occurring.

Figure 1 is a schematic view of a touch sensor formed in accordance with an exemplary embodiment of the present invention.

Figure 2 is a schematic view of the touch sensor shown in Figure 1 shown in various stages of a touch event.

Figure 3 is a timing chart of an exemplary operation of the touch sensor shown in Figure 1.

Figure 4 is a schematic view of an exemplary device using the touch sensor shown in Figure 1.

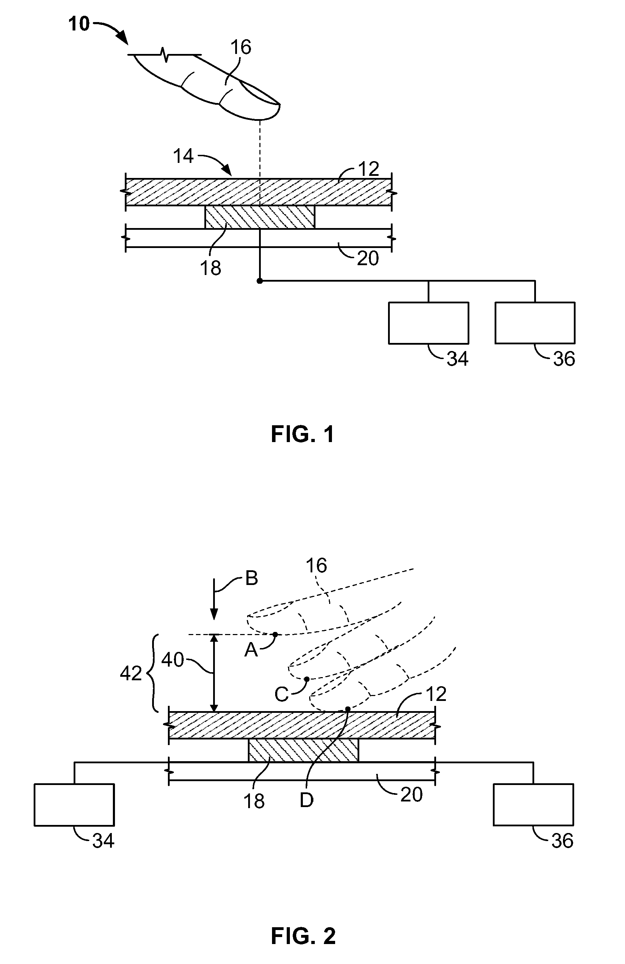

Figure 1 is a schematic view of a touch sensor 10. The touch sensor 10 is mounted under a dielectric element 12 and is illustrated in a "touch" condition since a sensing location 14 of the dielectric element 12 is touched by a finger 16 of a user. A touch event occurs when a user physically touches the sensing location 14 or when a user is in close proximity to the sensing location 14, such that the user is interacting with the touch sensor 10. The interaction between the user and the touch sensor 10 is illustrated by the dashed line in Figure 1. Optionally, the user may be capacitively interacting with the touch sensor 10, wherein the touch sensor 10 detects the capacitive coupling between the user's finger 16 and the touch sensor 10. Alternatively, the user may interact with the touch sensor 10 in other detectable ways, such as by an electro-magnetic interaction, an electronic field, a field disturbance, a charge transfer, a radiation transfer, and the like.

The touch sensor 10 includes a conductive pad 18 located under the dielectric element 12. The pad 18 is in registry with the sensing location 14 on the dielectric element 12. The touch sensor 10 also includes a circuit board 20 having control circuitry thereon which defines a touch circuit. The pad 18 is connected to the circuit board 20. Optionally, the pad 18 may be a solid conductive pad or the pad 18 maybe a plurality of conductive circuit board traces on the circuit board 20 concentrated at the sensing location 14. While the touch sensor 10 is illustrated and described with reference to a capacitive touch sensor, it is realized that other types of touch sensors may be used. For example, electronic field touch sensors, field disturbance touch sensors, charge transfer touch sensors, radiation transfer touch sensors, and the like.

The sensing location 14, the corresponding conductive pad 18 and the control circuitry associated with the pad 18 are referred to as a "key". If appropriate, markings may be provided to indicate to the user the exact location where the finger 16 has to touch to achieve a touch condition at the key. Of course, a person skilled in the art would realize that the term "finger" may be substituted for any body part that can be used for touching a key. Either a single key, or a plurality of keys, are arranged to define a keyboard, which may be used for home, office or industrial use.

In operation, the touch circuit uses the interaction between the user and the key to detect a touch event at the key. Signals are transmitted along the control circuitry to the respective keys as inputs or control signals from a control module 34. Optionally, the signals may be constant amplitude signals that are pulsed to the keys. Alternatively, the signals may be substantially continuously sent to the keys. Outputs or control signals from the keys that correspond to the inputs from the control module 34 are transmitted from the keys to an analyzing module 36. The outputs are representative of the interaction between the user and the key. During a touch event, a touch signal is sent as the output. During a no touch situation, a non-touch signal is sent as the output. The touch signals and the non-touch signals output from the keys are different than one another such that the analyzing module 36 can differentiate the touch event. Optionally, the signals may be changed due to the interaction of the user to the key. As a result, the touch signal may have a different amplitude than the non-touch signal.

Figure 2 is a schematic view of the touch sensor 10 shown in various stages of a touch event. In a first position, when a tip of the user's finger 16 is at point A, the user's finger 16 is positioned a distance 40 from the dielectric element 12. The distance 40 defines a maximum sensing distance for the key. The maximum sensing distance defines a sensing range 42 of the touch sensor 10. When the finger 16 is within the sensing range 42, the user's finger 16 is interacting with the pad 18, and the control circuitry associated with the key is detecting the presence of the finger 16. The maximum sensing distance may be based on factors such as a resolution of the touch sensor 10, an amount of noise surrounding the touch sensor 10, a sensitivity of the key, and the like.

The distance between the finger 16 and the pad 18 affect the touch signal output from the key. As the finger is moved in a touching direction, generally toward the key, such as in the direction of arrow B, the interaction between the finger 16 and the pad 18 is increased. As a result, a measured variable (e.g. the amplitude, capacitance, or field) of the output signal from the key may be changed as the finger moves generally toward the key. For example, when the finger 16 is in a second position (i.e. the tip of the finger 16 is at point C), the interaction between the finger 16 and the pad 18 is greater than when the finger 16 is in the first position. When the finger 16 is touching the dielectric element 12, (i.e. the tip of the finger 16 is at point D), a maximum interaction exists between the finger 16 and the pad 18.

A touch signal is output from the key when the finger 16 is in each of the positions illustrated in Figure 2, however, the measured variable (e.g. the amplitude, capacitance, or field) of the signal at each of these positions is different. Additionally, factors other than the position of the user's finger 16 with respect to the pad 18 affect the touch signal output from the key. For example, a thickness or type of material of the dielectric element 12 or air gaps between the dielectric element 12 and the pad 18 may affect the touch signal output from the key. The size or positioning of the pad 18 or variations in the control circuitry associated with the key may affect the touch signal output from the key. Environmental factors such as temperature or humidity or manufacturing variations may affect the touch signal output from the key. The size of the user or the size of the user's finger 16 may affect the touch signal output from the key. For example, an adult and a child may have different capacitances. Additionally, the way that a user touches the key may affect the touch signal output from the key. For example, hovering above the key may adversely affect the performance of the touch sensor 10. Hovering may cause a flickering output signal where the person is close to the maximum sensing distance, and the touch sensor 10 may detect an unwanted or inadvertent touch. Control algorithms or functions may be provided to compensate for some of these factors that may affect the touch signal output from the key. For example, control algorithms may provide equalization, calibration or adjustments to the sensitivities of the keys.

As described above, in an exemplary embodiment, the analyzing module 36 analyzes a change in a measured variable (e.g. the amplitude, capacitance, or field) of the touch signals over a time period to determine if a touch event is occurring. The touch signals may be analog signals or digital signals. The analyzing module 36 may measure the current or the voltage of the signal. Optionally, the analyzing module 36 measures the amplitude of the signal at constant time intervals to determine the change.

Each touch event has a touch pattern. A typical touch pattern includes an approach portion, an engaging portion, and a retraction portion. The finger 16 is moving toward the touch sensor 10 during the approach portion; the finger 16 is engaging or interfacing with the touch sensor 10 during the engaging portion; and the finger 16 is moving generally away from the touch sensor 10 during the retracting portion of the touch pattern.

The analyzing module 36 compares the touch pattern to an expected range or predetermined human pattern. The predetermined human pattern identifies a range of touch patterns that are typical of a human touch. The predetermined human pattern includes minimum and maximum values for factors such as the signal, a speed of the finger during the approach portion, or an amount of time for the engaging portion. If the touch pattern is within the expected range, then the analyzing module 36 will verify the touch event. If the touch pattern is not within the expected range, then the analyzing module 36 will disregard the signals. For example, if the finger 16 approaches too slowly or too quickly, than the analyzing module 36 will disregard the signal as being non-normal human behavior and treat the event as a no touch event. As a result, the touch event is determined based on the change in the measured variable being within a predetermined range that corresponds to typical human behavior. The touch event is not determined based for the most part on the absolute value of measured variable being within a certain threshold, but rather, is based on the variation on the variable over a time period. As such, the touch sensor 10 is less dependent on the actual signal, and is less dependent on the factors that may affect the touch signal output, such as the sensitivity of the keys, the thickness or type of dielectric material 12, and other similar factors.

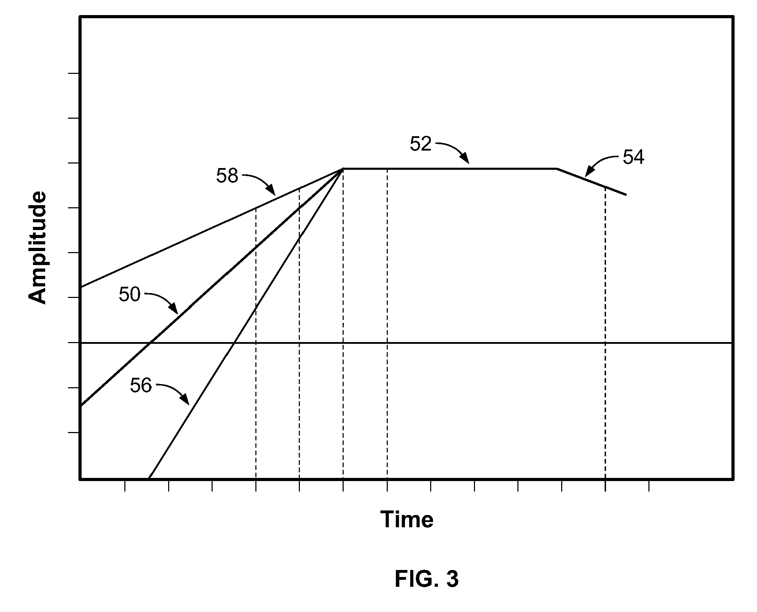

Figure 3 is a timing chart of an exemplary touch event detected by the touch sensor 10. The timing chart illustrates the measured amplitude of the output signal versus time. The touch event illustrated in Figure 3 has a touch pattern having an approach portion 50, an engaging portion 52, and a retraction portion 54. The approach portion 50 has a positive slope defining the change of the amplitude over a time period. The slope is substantially constant, indicating that the speed of approach of the user's finger 16 (shown in Figure 1) is constant. Alternatively, the touch pattern may have a curved approach portion indicating that the speed of the user's finger 16 is changing as the user is approaching the touch sensor 10. Optionally, the analyzing module 36 may sample the output signal at predetermined sampling times to determine the slope of the approach portion. The timing chart also illustrates a minimum detection signal. The minimum detection signal is a minimum threshold signal, and is based on various factors such as the amount of noise, the key sensitivity, the dielectric element 12 (shown in Figure 1), the control circuitry, and other environmental and manufacturing factors.

The timing chart also illustrates an exemplary human pattern for a touch event. The human pattern is illustrated with a slowest finger movement path 56 and a fastest finger movement path 58, which together define an expected range of speeds for finger movements. In the illustrated embodiment, the touch pattern is within the range of speeds, and the analyzing module 36 would consider the information for further analysis.

The engaging portion 52 of the touch pattern corresponds to the user interfacing with the dielectric element 12. The amplitude of the signal in the engaging portion 52 is constant as the user's finger 16 remains at a constant position relative to the pad 18 (shown in Figure 1). The retracting portion 54 of the touch pattern corresponds to the user's finger 16 moving away from the pad 18. The amplitude of the signal in the retracting portion 54 is lower than in the engaging portion. The slope of the signal may be substantially constant or the slope may be curved, depending on the speed that the user's finger is removed.

Optionally, a touch event may be verified by the analyzing module 36 based on a portion of the touch pattern. For example, the analyzing module 36 may verify a touch event based on an approaching portion 50 within the expected range and the engaging portion 52 lasting for a predetermined time, such as a predetermined amount of sampling time. As such, the retracting portion of the touch pattern is not needed to verify a touch event.

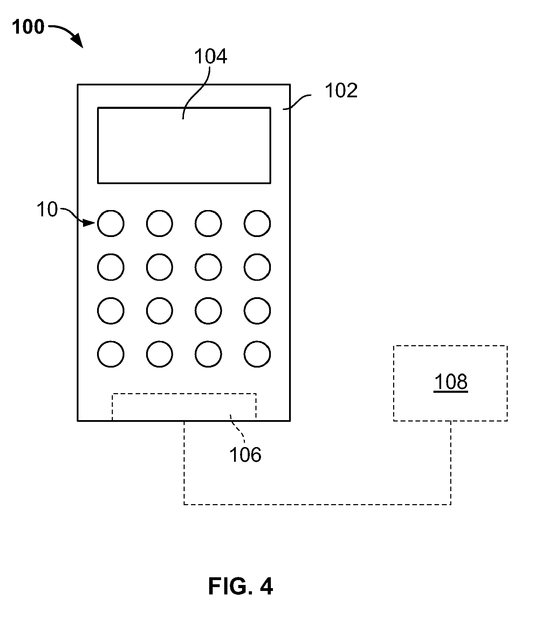

Figure 4 is a schematic view of an exemplary device 100 using the touch sensor 10. The device 100 includes a housing 102 holding the touch sensor 10. Optionally, the device 100 may include a display 104. The device 100 may include an internal controller 106, shown in phantom in Figure 4. The device 100 may communicate with a secondary device, machine or system 108 via a wired connection or a wireless connection. Touches at the touch sensor 10 may be used to control the device 100 and/or the secondary device, machine or system 108.

A touch sensor 10 is thus provided that operates in a cost effective and reliable manner. The touch sensor 10 includes a keyboard having keys and associated control circuitry. The touch sensor 10 is operated using a control module 34 that inputs signals to the control circuitry, and an analyzing module 36 that receives output signals from the control circuitry. The analyzing module 36 analyzes the variation or change of a measurable variable of the control signals over a time period to determine if a touch event is occurring. The measurable variable may be a variable such as an amplitude or capacitance. The analyzing module also compares the measured variable with an expected range of measurements to verify that a valid touch event is occurring. By analyzing the change in measured variables rather than the absolute value of the variable, a dynamic touch sensor is provided that is less dependent on factors that negatively affect the touch sensors ability to accurately and consistently measure the absolute value of the variable. As a result, the touch sensor 10 provides accurate response to touch events in an efficient manner.

While the invention has been described in terms of various specific embodiments, those skilled in the art will recognize that the invention can be practiced with modification within the spirit and scope of the claims.

## Claims

1. A touch detection system comprising:
a touch sensing module having a key defining a touch sensing location, the key being responsive to at least one of capacitive and electro-magnetic interactions with a user during a touch event;
a control module sending an input signal to the key, wherein an amplitude of the control signal is representative of an amount of the interaction between the user and the key during a touch event, and wherein the amplitude of the input signal is changed during the touch event of the key; and
an analyzing module receiving an output signal from the key, the analyzing module analyzing a variation in an amplitude of the output signal over a time period to verify the touch event.

2. A touch detection system in accordance with claim 1, wherein the control module sends one of a pulsed signal and a continuous signal to the key.

3. A touch detection system in accordance with claim 1, wherein the variation in the amplitude of the output signals constitutes an approach speed of the user during the touch event.

4. A touch detection system in accordance with claim 1, wherein the output signal includes a touch signal when the touch event occurs at the associated key and the output signal includes a non-touch signal when no touch event occurs at the associated key, wherein the analyzing module analyzes the variation in the amplitude of the touch signal to verify the touch event.

5. A touch detection system in accordance with claim 1, wherein the output signal varies based on a position of a user's body in relation to the key.

6. A touch detection system in accordance with claim 1, wherein the variation in the amplitude of the output signal over the time period relates to an approach speed of the user during the touch event, the analyzing module identifying an upper threshold speed and a lower threshold speed, the analyzing module verifying the occurrence of the touch event based on the approach speed being below the upper threshold speed and above the lower threshold speed.

7. A method of detecting a touch event using the touch detection system of claim 1, said method comprising:
generating an output signal at the key corresponding to a proximity of an object to the key, wherein an amplitude of the output signal is varied depending on the proximity of the object to the key; and
analyzing a change in the amplitude of the output signals over a time period to determine that a touch event is occurring.

8. A method in accordance with claim 7, wherein the variation in amplitude of the output signal relates to an approach speed of the user during the touch event, said analyzing comprises verifying that the approach speed is within a predetermined range of approach speeds.

9. A method in accordance with claim 7, wherein the variation in amplitude of the output signals over the time period relates to an approach speed of the user during the touch event, said method further comprising identifying an upper speed threshold and a lower speed threshold, said analyzing comprises verifying that the approach speed is below the upper speed threshold and above the lower speed threshold.

10. A method in accordance with claim 7, wherein said generating an output signal comprises generating a touch signal when the touch event occurs at the associated key and generating a non-touch signal when no touch event occurs at the associated key, said analyzing a change in the amplitude of the output signal comprises analyzing the variation in amplitude of the touch signal to verify that a touch event is occurring.
